# EUROPEAN PATENT APPLICATION

(11) **EP 1 041 002 A2**
(43) Date of publication of application: **04.10.2000**
(21) Application number: 00106877.4
(22) Date of filing: 31.03.2000
(51) Int. Cl.: B64G 1/52, B64G 1/50, H05K 7/20

(54) **Protective casing with cooling for equipment in air, space or land vehicles**

(30) Priority: 01.04.1999 IT TO990256
(71) Applicant: Negesat Di Boer Fabrizio & C. SNC, 10073 Cirie' (Torino) (IT)
(72) Inventor: Bodini, Amedeo, 26000 Cremona (IT)
(74) Representative: Robba, Pierpaolo

(57) **Abstract**

A system of mechanical restraint and heat dissipation for equipment of space, air or land vehicles including at least one structure housing electronic components and/or apparatuses, said system comprising elements (8) of elastic-damping material (10), coated with at least one layer (11) of a thermally conductive material, said elements being located inside said apparatuses and/or between the apparatuses, inside said structure.

## Description

The present invention concerns a system of mechanical restraint and heat dissipation for space, air or land vehicles.

More particularly, the invention concerns a system of mechanical restraint and heat dissipation for the components of electronic equipment and the relevant housing structure within a vehicle undergoing a strong acceleration such as a space vehicle, e. g. a satellite, at the launch.

Space vehicles, such as for instance telecommunication satellites, generally carry inside them a plurality of racks housing electronic equipment intended for vehicle operation (subsystem load) or for performing the functions the vehicle has been constructed for (payload).

Said equipment includes for instance batteries, signal transponders, data handling equipment, converters, repeaters, television cameras, transmitters, etc.

Each equipment apparatus has, inside the space vehicle, a pre-set fixed position, determined according to the rack sizes, the heat dissipation coefficient, the centre of gravity, the stiffness, the immunity from electromagnetic interference and so on.

Moreover, the apparatuses are usually connected with one another by a plurality of electric conductors or wirings.

Most electronic equipment comprises a plurality of adjoining boards, mounted on a motherboard and fastened to the walls of the rack housing the equipment.

Under certain circumstances, when an improved heat dissipation is required, according to the prior art a highly thermally conductive, but electrically insulating, material or hardening solution is arranged inside the equipment rack and between the boards, to allow dissipating the heat developed by the boards towards the outside of the equipment through the rack walls.

The above solution however has the drawback that it considerably increases the equipment mass; moreover, the hardening solution, once hardened, is no longer capable of absorbing mechanical vibrations.

In space missions where, at the launch, the equipment is stressed by an extremely high load, generally the use is recommended of small elements of silicone, inserted into the gaps between the boards, in order to damp mechanical vibrations.

Yet that solution does not ensure an improvement of the heat exchange within the equipment and, further, still has the drawback of increasing the equipment mass.

Other known solutions provide for housing the equipment within the vehicle in suitable structures, to which the equipment is rigidly secured through bolts.

The known solutions however have the drawback that they submit the equipment to an amplified load due to the dynamic coupling which takes place between the equipment racks and the structure housing them within the vehicle.

Indeed, a dynamic coupling takes place whenever the equipment content undergoes an (output) acceleration, which is far higher than the (input) acceleration applied to the satellite fastening structure.

Thus, when the vehicle is to undergo a high acceleration, the use of special and complex structures is required for supporting the load, thereby increasing the overall satellite mass and cost.

Moreover, if the electronic equipment develops, during its normal operation, a high heat amount, also a system for heat dissipation will have to be provided within the structure housing the equipment.

Generally, in such system, heat exchange takes place by conduction through honeycomb panels made of aluminium, the equipment being located adjacent to said panels and being firmly secured thereto by means of inserts provided in the same panels.

Heat generated by the electronic equipment is therefore conveyed to the outside of the structure first from the components on the boards to the board supports in the equipment rack through especially designed conductive paths, then through the honeycomb panels, and is subsequently eliminated by radiation into the empty space.

In the most favourable cases, heat is directly dissipated by the rack walls by radiation to the empty space and by conduction on suitably milled aluminium walls.

In very special cases, use is made of heat pipes exploiting the latent heat of a fluid passing from liquid to gaseous state, which pipes are glued onto the equipment walls.

Those solutions however present some drawbacks.

The active surface for heat exchange between the racks and the honeycomb panels is limited. In fact only one face of the rack contributes to dissipating the thermal power generated.

A rigid structural coupling exists between the equipment and the structure housing it and consequently a dynamic amplification of the accelerations undergone by the satellite takes place, such amplification being in some cases up to 20-30 times the input acceleration at the resonance frequencies. This results in the necessity of over-dimensioning both the restraining structures for the electronic components and the assembling of the electronic boards within the equipment racks, thereby increasing the weight and consequently reducing the payload and hence the effectiveness/costs ratio.

Lastly, the solution using heat-pipes is very expensive.

Therefore, it is an object of the present invention to provide a system with reduced mass for dissipating heat developed by electronic equipment within the satellite, which system allows moreover damping mechanical vibrations, thereby resulting in a practically negligible dynamic amplification.

A second object of the present invention is to provide a system of mechanical restraint and heat dissipation which is cheap and easy to manufacture, and which moreover can be implemented both within the equipment racks and between the equipment and the structure housing it.

The above and other objects are achieved by the system of mechanical restraint and heat dissipation for space vehicles, as claimed in the appended claims.

The above and other objects of the invention will become more apparent from the description of a preferred embodiment, with reference to the accompanying drawings in which:
- Fig. 1 shows the system of the invention in a structure including a plurality of electronic apparatuses;
- Fig. 2 shows the system of the invention in a structure including a plurality of boards;
- Fig. 3 is a cross-sectional view of an element of mechanical restraint and heat dissipation according to a first embodiment of the invention;
- Fig. 4 is a schematic view of a portion of the material for mechanical restraint and heat dissipation according to a second embodiment of the invention.

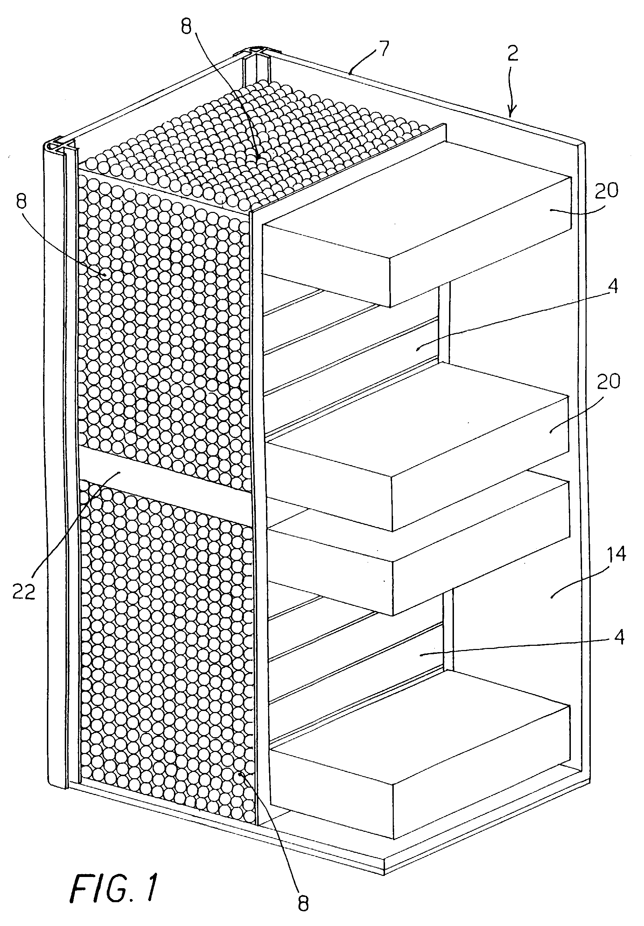

With reference to Fig. 1, a parallelepiped-shaped mechanical restraint structure 2, suitable for fitting into a satellite or space vehicle, houses a plurality of apparatuses 4 connected with one another and/or with apparatuses located outside casing 7 of structure 2 through electrical connectors, not shown in the drawing.

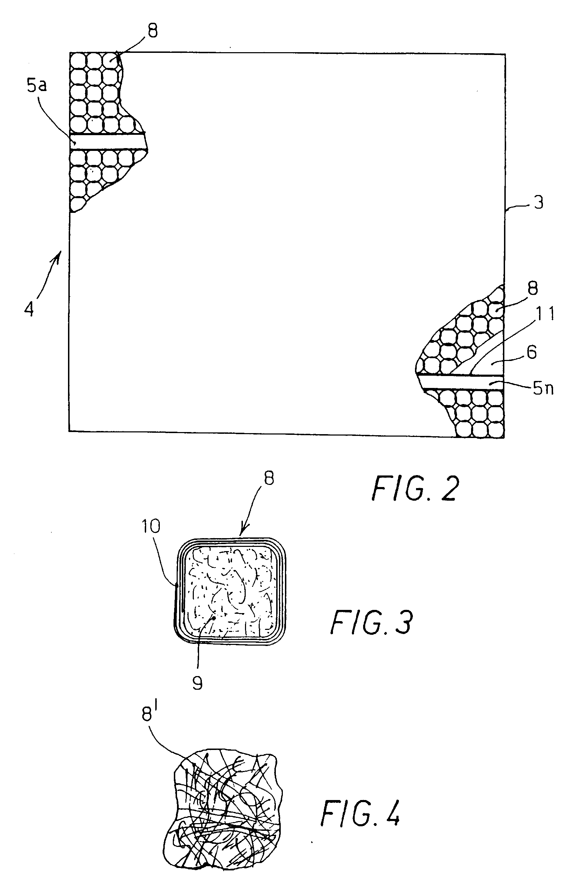

As better shown in Fig. 2, in the example depicted, apparatuses 4 house a plurality of boards 5a...5n mounted on a motherboard 6 and secured to the internal walls of rack 3 of apparatus 4 by means of well known securing means.

According to the invention, a plurality of elements 8 of elastic-damping material coated with a thermally conductive layer are arranged between boards 5a - 5n.

As shown in Fig. 3, elements 8 comprise a body 9, of a light elastic-damping material, coated with at least one layer 10 of a material having high thermal conductivity.

Preferably, according to the invention, elements 8 are made as cuboids 9 with sides of about 10 mm, of a low-density (5 to 30 Kg/m³) polymeric material, for instance polystyrene, polyurethane, polypropylene, polyethylene etc. Cubes 9 are moreover coated with one or more layers 10 of a material having high thermal conductivity, such as aluminium, copper, silver, gold etc., each layer being about 15 µm thick.

In this way, elements 8 will have on the one side high damping properties and on the other side a good capability of heat transmission by conduction.

Coating of cubes 9 can be effected, according to known techniques, both manually and automatically, by wrapping cubes 9 into a copper, aluminium or silver foil so as to form successive wrapping layers, in such a manner that the elastic-damping properties of the material of cubes 9 are not inhibited. It is also possible to provide a plurality of layers of thermally conductive material with different thicknesses, the limit being determined by the total inhibition of the elastic-damping properties of cubes 9.

In the alternative, bodies 9 of elements 8 may have any shape, e. g. spherical, parallelepiped, cylindrical or prismatic, and be similarly coated with any film or paint with thermally conductive properties.

The size of individual elements 8 can be chosen at will, depending on the overall size requirements.

Of course, in case of non-pressurised racks, use of open-cell polymers will be preferable for bodies 9.

Since the material of coating 10 is also electrically conductive, the surfaces of boards 5a - 5n and motherboard 6 will have to be electrically insulated, yet in such a manner that thermal conductivity is not impaired.

Electrical insulation is obtained thanks to a mixture of a urethane resin in paste form, such as for instance the product available under the name Solithane 113 from Uniroyal Chemical, to which a thermally conductive and electrically insulating powder, such as aluminium oxide, is added.

Said mixture can moreover be supplemented with additives capable of conferring the proper hardness to thin film 11 obtained by spraying the mixture onto boards 5a - 5n.

In an exemplary embodiment of the invention the mixture will contain 50% aluminium oxide powder.

Advantageously, electronic boards 5a - 5n can be electrically insulated at the manufacturing plant, before being assembled into the apparatus, or later, by spraying the aforementioned insulating mixture.

Reverting to Fig. 1, some elastic-damping spacers 20, 22 assist, within casing 7 of structure 2, in maintaining apparatuses 4 in the proper position and in ensuring sufficient room for the electric cables.

According to the invention, a plurality of elements 8 of light elastic-damping material are arranged between the internal walls of casing 7 of structure 2 and apparatuses 4, said elements being coated with a thin layer (some micron thick) with high thermal conductivity (aluminium, copper, silver, gold).

Fig. 1 refers to the case where thermal dissipation is to take place through the walls of casing 7 of structure 2 which are not exposed to solar radiation, i. e. the side, rear, top and bottom walls.

Yet, retaining and dissipating elements 8 could also be arranged between apparatuses 4, if this is advantageous.

Considering the arrangement shown in Fig. 1, it is understood that, in case the walls of casing 7 of structure 2 coincide with the walls of a small satellite, the surface providing for heat exchange between apparatuses 4 and the cold walls of the satellite is considerably increased with respect to the conventional case in which the apparatuses are rigidly secured by screws onto a single wall.

Elements 8 are applied to several faces of each apparatus 4 and are crushed so as to maximise the heat exchange surface between the walls of apparatuses 4 and the walls of casing 7 of structure 2.

Elements 8, placed close to one another and pressed between the adjoining walls, form a conductive net having thermal conduction properties similar to those of a honeycomb-type panel made of aluminium, while keeping all advantages offered by the mechanical properties of polystyrene or other elastic-damping material.

Casing 7 of structure 2 can be hermetically sealed and contain air, an inert gas or a different cooling gas mixture or even a cooling liquid.

If casing 7 of structure 2 is hermetically sealed, the elastic-damping material could be a closed cell material, such as polystyrene; otherwise use of an open cell material will be necessary.

Yet it is possible to use a closed cell elastic-damping material also in the vacuum, provided that said material is compacted in the assembling phase in such a way that the residual volume that would be occupied in the expansion phase due to pressure drop would be insufficient to cause its explosion. If conductive film 10 wrapping bodies 9 also acts as a coating elastically opposing the expansion of the closed cell material, the latter could be used without problems also in the vacuum.

That coating could also effectively keep inside elements 8 the molecules of bodies 9 degassing in the vacuum.

Moreover, if casing 7 of structure 2 is hermetically sealed, thermal dissipation could be increased by introducing, inside casing 7 of structure 2, some fans, not shown in drawings, which fans start a process of forced ventilation and therefore of air convection. In the absence of gravity in fact convection would be practically absent.

The inside of casing 7 of structure 2 is maintained pressurised at ambient pressure thanks to the sealing made in terrestrial environment by using non structural glues, which guarantee the tightness without jeopardising a possible accessibility to the inside of the satellite for a last minute repair.

If, on the contrary, casing 7 of structure 2 is not hermetically sealed, a simple heat exchange by conduction is obtained, the exchange being improved by the presence of several thermally conductive faces.

From the mechanical standpoint, an isostatic configuration is obtained in the whole, each apparatus being constrained by compression on all six faces.

The advantages of that architecture are underlined by the fact that, by improving, on the one side, the dissipation properties of the apparatuses and, on the other side, the possibility of designing the assembly and the components for lower load factors, components and assembling methods designed for terrestrial use, which have much lower costs than those specifically intended for the present space vehicles, are potentially utilisable, while separately and specifically providing a suitable protection against cosmic radiation.

With reference to Fig. 4, there is shown a portion of a material for mechanical restraint and heat dissipation according to a second embodiment of the invention, where use is made of iron or aluminium or copper wool as elastic-damping and thermally conductive material, as an alternative to the polymeric elements coated with a thermally conductive material.

As known, both aluminium and copper have optimum thermal conductivity properties, whereas friction between wool fibres 8' ensures a damping and elastic action.

Advantageously, copper or aluminium wool could be used both inside apparatuses 4, as a structure multiplying the thermal paths between the components and the casing walls and as mechanical damping unit for the boards, and outside apparatuses 4, as a system for assembling one or more apparatuses 4 within casing 7 ensuring equivalent thermo-mechanical performance to elements 8 according to the first embodiment of the invention.

Even though the invention has been disclosed with reference to a vehicle for space use, it can however be advantageously employed even in an air or land vehicle where the same result has to be achieved.

## Claims

1. A system of mechanical restraint and heat dissipation for electronic components and/or equipment carried on board of space or air or land vehicles, characterised in that it comprises a plurality of elements (8) including a body (9) of elastic-damping material, coated with at least one layer (10) of a thermally conductive material.

2. A system according to claim 1, wherein said vehicle includes at least one structure (2) for housing electronic equipment (4) and wherein said elements (8) are located inside said equipment (4) and/or outside said equipment (4), inside the casing (7) of said structure (2).

3. A system according to claim 2, wherein said bodies (9) of elastic-damping material have a spherical, cuboid or prismatic shape.

4. A system according to claim 2 or 3, wherein said layer (10) of thermally conductive material is a layer of aluminium, copper, silver or gold.

5. A system according to claim 2 or 3 or 4, wherein the size or the number of said elements (8) are such that they become partially crushed when they are located inside said equipment (4) and/or between apparatuses in said equipment (4), inside said structure (2).

6. A system according to any preceding claim, wherein said bodies (9) are made of a polymeric material.

7. A system according to claim 6, wherein said polymeric material is polystyrene, polypropylene, polyurethane, polyethylene.

8. A system according to claim 6, wherein said casing (7) is hermetically sealed and contains air.

9. A system according to claim 6, wherein said casing (7) is hermetically sealed and contains a cooling fluid.

10. A system according to any of claims 2 to 5, wherein the casing (7) of the structure (2) is not pressurised and said bodies (9) are made of a polymeric material coated with or compressed by a material preventing its expansion and the consequent explosion.

11. A system of mechanical restraint and heat dissipation for electronic components and/or equipment carried on board of space or air or land vehicles, characterised in that it comprises a compacted wool of fibres (8') of thermally conductive material.

12. A system according to claim 11, wherein said vehicle includes at least one structure (2) for housing electronic equipment (4) and wherein said wool is located inside said equipment (4) and/or outside said equipment (4), inside said structure (2).

13. A system according to claim 12, wherein said wool is an iron, steel, aluminium, copper, silver or gold wool.

14. A space, air or land vehicle carrying electronic components and/or equipment, characterised in that it comprises a system of mechanical restraint and heat dissipation as claimed in any of claims 1 to 13.
